# FASCICULE DE BREVET EUROPEEN

(11) **EP 3 701 567 B1**
(45) Date de publication et mention de la délivrance du brevet: **03.11.2021**
(21) Numéro de dépôt: 18814987.6
(22) Date de dépôt: 17.10.2018
(51) Int. Cl.: H01L 29/66, H01L 29/423, H01L 29/06, B82Y 10/00, B82Y 40/00

(54) **PROCEDE DE FABRICATION D'UN COMPOSANT ELECTRONIQUE A DOUBLES BOITES QUANTIQUES**
VERFAHREN ZUR HERSTELLUNG EINES ELEKTRONISCHEN BAUTEILS MIT DOPPELQUANTENPUNKTEN
METHOD FOR PRODUCING AN ELECTRONIC COMPONENT WITH DOUBLE QUANTUM DOTS

(30) Priorité: 26.10.2017 FR 1760103
(43) Date de publication de la demande: 02.09.2020
(73) Titulaire: Commissariat à l'énergie atomique et aux énergies alternatives, 75015 Paris (FR)
(72) Inventeur: BARRAUD, Sylvain, 38690 Le Grand Lemps (FR); HUTIN, Louis, 38950 Saint Martin Le Vinoux (FR); VINET, Maud, 38640 Claix (FR)
(74) Mandataire: INNOV-GROUP
(86) Numéro de dépôt international: PCT/FR2018/052592
(87) Numéro de publication internationale: WO 2019/081837

(56) Documents cités:
- WO-A1-2008/044828
- WO-A2-2007/127523
- US-A1- 2015 279 981
- US-A1- 2016 300 155
- HUTIN L ET AL: "SOI CMOS technology for quantum information processing", 2017 IEEE INTERNATIONAL CONFERENCE ON IC DESIGN AND TECHNOLOGY (ICICDT), IEEE, 23 mai 2017 (2017-05-23), pages 1-4, XP033131249, DOI: 10.1109/ICICDT.2017.7993523

## Description

L'invention concerne les composants électroniques à boîte ou îlot quantique, et plus particulièrement les procédés de fabrication de composants électroniques à doubles boîtes ou îlots quantiques.

L'électronique quantique fournit une base pour des améliorations de performances. Par analogie avec l'électronique classique, le bit quantique représente l'élément de base du calcul pour l'électronique quantique. En électronique classique, des calculs booléens sont réalisés à partir de bits présentant un état parmi deux possibles. Un bit quantique est une superposition des états propres |0> et |1>.

Les boîtes ou îlots quantiques servent d'éléments de base à l'électronique quantique. Les boîtes quantiques utilisent des nanostructures de semiconducteurs pour former des puits de potentiel pour confiner des électrons ou des trous dans les trois dimensions de l'espace. L'information quantique est alors codée dans des degrés de liberté purement quantiques : actuellement le spin ½ de l'électron. Les boîtes quantiques visent à piéger un électron isolé pour mémoriser un qubit. Les boîtes quantiques permettent alors de bénéficier de capacités de calcul décuplées par rapport à un système utilisant une logique binaire.

Le document intitulé 'Dispersively detected Pauli Spin Blockade in a silicon nanowire FET', publié par Betz et alias le 4 Mai 2015, décrit un composant électronique quantique. La fabrication du composant électronique comprend la fourniture d'un substrat surmonté d'une couche de matériau semi-conducteur. La couche de matériau semi-conducteur fait l'objet d'une gravure pour définir le motif d'un nanofil. Des première et deuxième couches de matériau diélectrique sont ensuite déposées pleine plaque.

La fabrication comprend ensuite une étape de définition d'un masque de photolithographie avec alignement de motifs de grille sur le nanofil semi-conducteur, de sorte que le masque de photolithographie soit en retrait par rapport à des bords opposés du nanofil semi-conducteur. La fabrication comprend ensuite une étape de gravure des couches diélectriques selon les motifs de grille, pour découvrir les bords supérieurs opposés du nanofil, ainsi que des faces latérales du nanofil dans le prolongement de ces bords. Un isolant de grille et un matériau de grille sont ensuite déposés sur les parties découvertes du nanofil, correspondant aux motifs de gravure.

Un tel procédé présente des inconvénients. D'une part, l'alignement des grilles par rapport à l'axe du nanofil semiconducteur est délicat à réaliser pour des dimensions réduites du nanofil. D'autre part, la surface de substrat utilisée par le dispositif est importante, la distance minimale entre les grilles étant définie par la largeur minimale disponible pour un motif de photolithographie. Pour permettre un débordement des grilles sur les bords du nanofil, la largeur du nanofil doit également être plus importante que cette largeur minimale du motif de photolithographie, ce qui nuit encore à la densité d'intégration. Un nanofil relativement large nuit également au couplage entre les îlots quantiques.

Le document US2016300155 décrit succinctement une structure d'un dispositif à Qbit. Le document décrit la formation de deux électrodes sur une couche d'isolant de grille recouvrant un nanofil. Un procédé de fabrication est décrit brièvement et inclut la formation de nanofils sur un substrat SOI. Un empilement de grille est ensuite formé par dépôt d'une couche de HfSiON, recouverte d'une couche de TiN et d'une couche de Silicium polycristallin. Le document mentionne la séparation de deux grilles par une gravure.

Le document 'SOI Technology for Quantum Information Processing', rédigé par L. Hutin et alias, publié dans le cadre de la conférence 2016 IEEE International Electron Devices Meeting (IEDM), décrit une structure à doubles boîtes quantiques et doubles grilles. Un procédé de fabrication décrit très succinctement la mise en forme d'un nanofil, la formation d'un isolant sur le nanofil par oxydation thermique, puis le dépôt d'un empilement d'isolant de grille et de métal de grille.

Le document WO2008/044828 décrit un procédé de formation d'un dispositif à boîte quantique, avec deux grilles séparées d'un masque, qui est déposé avant le dépôt du matériau de grille.

L'invention vise à résoudre un ou plusieurs de ces inconvénients. L'invention porte ainsi sur un procédé de fabrication d'un composant électronique à doubles boîtes quantiques et doubles grilles, tel que défini dans la revendication 1, annexée.

L'invention porte également sur les variantes des revendications dépendantes. L'homme du métier comprendra que chacune des caractéristiques des revendications dépendantes peut être combinée indépendamment aux caractéristiques de la revendication indépendante.

D'autres caractéristiques et avantages de l'invention ressortiront clairement de la description qui en est faite ci-après, à titre indicatif et nullement limitatif, en référence aux dessins annexés, dans lesquels :
- la figure 1 est une vue de dessus d'un exemple de composant électronique à doubles boîtes quantiques fabriqué avec un procédé selon un premier mode de réalisation de l'invention ;
- la figure 2 est une vue en coupe transversale d'une double boîte quantique fabriqué avec un procédé selon le premier mode de réalisation de l'invention ;
- la figure 3 est une vue en coupe transversale d'une double boîte quantique fabriqué avec un procédé qui n'est pas couvert par l'invention;
- la figure 4 est une vue en coupe transversale d'une double boîte quantique fabriqué avec un procédé selon un deuxième mode de réalisation de l'invention ;
- les figures 5 à 8 sont des vues en coupe transversale du composant de la figure 1 à différentes étapes d'un exemple de procédé de fabrication ;
- les figures 9 à 11 sont des vues en coupe longitudinale du composant au stade de fabrication illustré à la figure 8 dans différents plans ;
- la figure 12 est une vue en coupe transversale du composant de la figure 1 selon une variante du procédé de fabrication du premier mode de réalisation ;
- la figure 13 est une vue en coupe transversale du composant de la figure 1 selon une autre variante du procédé de fabrication du premier mode de réalisation ;
- les figures 14 à 17 sont des vues en coupe du composant à une étape ultérieure d'une variante du premier mode de réalisation ;
- les figures 18 à 21 sont des vues en coupe du composant à une étape ultérieure d'une variante du premier mode de réalisation ;
- les figures 22 à 24 sont des vues en coupe du composant à une étape ultérieure d'une variante du premier mode de réalisation ;
- les figures 25 à 28 sont des vues en coupe du composant à une étape ultérieure d'une variante du premier mode de réalisation ;
- les figures 29 à 32 sont des vues en coupe du composant à une étape ultérieure d'une variante du premier mode de réalisation ;
- les figures 33 à 36 sont des vues en coupe du composant à une étape ultérieure d'une variante du premier mode de réalisation ;
- la figure 37 est une vue en coupe transversale d'un empilement vertical de composants électroniques, obtenu avec un procédé qui n'est pas couvert par l'invention.
- la figure 38 est une vue en coupe transversale d'un empilement vertical de composants électroniques, obtenu selon une variante du procédé de fabrication du premier mode de réalisation.

L'invention propose un procédé de fabrication d'un composant électronique à doubles boîtes ou îlots quantiques (usuellement désigné par le terme de double quantum dots en langue anglaise) et doubles grilles (usuellement désigné par le terme Split-Gate en langue anglaise). L'invention propose de fournir un empilement d'une couche de matériau semi-conducteur et d'une couche de matériau diélectrique formée au-dessus de la couche de matériau semi-conducteur. Après formation d'un masque sur l'empilement, on réalise une gravure de la couche de matériau diélectrique et de la couche de matériau semi-conducteur selon le motif du masque pour obtenir un empilement d'un nanofil semi-conducteur et d'un nanofil de diélectrique. Une partie de la largeur du masque est alors gravé sélectivement par rapport au nanofil et un isolant de grille est formé sur les flancs latérales du nanofil. Un matériau de grille est ensuite déposé pleine plaque. Une planarisation chimique est ensuite réalisée jusqu'à atteindre le nanofil de diélectrique, de façon à former des première et deuxième grilles isolées électriquement l'une de l'autre par ce nanofil de diélectrique.

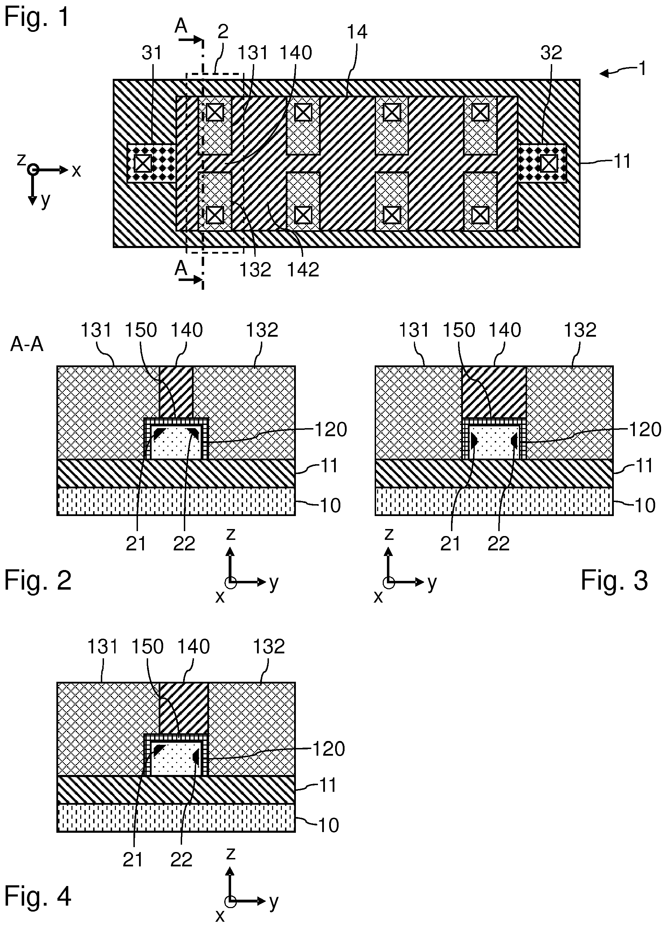

La figure 1 est une vue de dessus d'un exemple de circuit électronique 1 réalisé selon un procédé de fabrication selon l'invention. Dans un souci de lisibilité, un système d'axes est ici illustré, l'axe X définissant par la suite la direction longitudinale, l'axe Y définissant par la suite la direction transversale et l'axe Z définissant par la suite la direction verticale. Le circuit électronique 1 illustré est uniquement donné à titre d'exemple car il inclut au moins un composant 2 à doubles boîtes quantiques et à doubles grilles. D'autres structures de circuits électroniques peuvent bien entendu être réalisées avec un procédé de fabrication selon l'invention. Le circuit électronique 1 illustré inclut ainsi plusieurs composants 2 connectés en série. Les composants électroniques 2 sont ainsi connectés en série entre un premier accès 31 et un deuxième accès 32.

La figure 2 est une vue en coupe transversale d'un composant électronique 2 de la figure 1, obtenu selon un premier mode de réalisation. La figure 2 illustre davantage la structure du composant électronique 2 et du circuit électronique 1.

Le composant électronique 2 est ici formé sur un substrat de type silicium sur isolant. Le substrat comporte ainsi de façon connue en soi une couche de silicium 10 recouverte d'une couche d'isolant enterré 11 (s'étendant dans un plan incluant les directions X et Y). Un nanofil de matériau semi-conducteur 120 (ici en silicium ou en alliage de silicium) est formé sur la couche d'isolant enterré 11 et s'étend selon la direction X. Le nanofil de silicium 120 est ici illustré en coupe au niveau de sa partie médiane, formant une zone de formation de boîtes ou îlots quantiques. Cette partie médiane du nanofil 120 est recouverte d'une couche d'isolant de grille 150, sur sa face supérieure et sur ses faces latérales. Dans cette partie médiane, une première boîte quantique 21 est formée à proximité d'une arête entre la face supérieure et une face latérale du nanofil 120, une deuxième boîte quantique 22 étant formée à proximité d'une arête entre la face supérieure et l'autre face latérale du nanofil 120. Les boîtes quantiques sont configurées pour piéger une particule unique (un électron ou un trou le cas échéant) afin de permettre de modifier ou lire l'état de son spin. Un masque dur en matériau diélectrique 140 est disposé à la verticale du nanofil semi-conducteur 120, sur la couche d'isolant de grille 150. Au niveau de la partie médiane du nanofil 120, des grilles de commande 131 et 132 sont ménagées de part et d'autre de l'empilement du nanofil 120 et du masque dur 140. Les grilles de commande 131 et 132 sont ainsi isolées électriquement l'une de l'autre, par l'intermédiaire de la couche d'isolant de grille 150 et du masque dur 140 de séparation.

Dans le présent mode de réalisation, l'empilement du nanofils 120 et du masque dur 140 présente une symétrie par rapport à un plan incluant les directions X et Z. Dans le présent mode de réalisation, le masque dur 140 est moins large que l'empilement du nanofil 120 et de la couche d'isolant de grille 150. Les grilles 131 et 132 présentent ici un débordement au-dessus de l'isolant de grille 150 et du nanofil 120. Une telle configuration facilite le positionnement des boîtes quantiques 21 et 22 à proximité des arêtes entre la face supérieure et les faces latérales de l'isolant de grille 150. Les boîtes quantiques 21 et 22 peuvent ainsi être rapprochées l'une de l'autre pour améliorer leur couplage, et leur distance peut être inférieure à ce que permettrait normalement la largeur minimale de photolithographie permettant de définir la largeur du nanofil 120 par gravure. De même, une telle configuration permet d'obtenir une distance entre les grilles 131 et 132 inférieure à la largeur minimale de photolithographie, selon un procédé de fabrication qui sera détaillé par la suite. Une telle configuration permet d'utiliser un nanofil 120 d'une largeur minimale, ce qui permet d'accroître les interférences entre les boîtes quantiques, et ainsi de réduire le potentiel nécessaire pour un accès en lecture des boîtes quantiques, et d'augmenter la vitesse de lecture de ces boîtes quantiques.

Le nanofil 120 s'étend de part et d'autre des grilles 131 et 132 (et des boîtes quantiques 21 et 22) selon la direction longitudinale X. Le nanofil 120 comporte ainsi des première et deuxième électrodes de conduction formées de part et d'autre des boîtes quantiques 21 et 22. Les différents composants électroniques 2 sont ici connectés en série par l'intermédiaire des électrodes de conduction formées dans leur nanofil 120 de matériau semi-conducteur. Une électrode de conduction d'un premier composant 2 est connectée au premier accès 31, une électrode de conduction d'un autre composant 2 étant connectée au deuxième accès 32.

Les grilles des différents composants 2 sont isolées électriquement les unes des autres par des séparations 142 formées dans le même matériau diélectrique que le masque dur 140.

La figure 3 est une vue en coupe transversale d'un composant électronique 2, obtenu avec un procédé qui n' est pas couvert par l'invention. Le composant 2 de la figure 3 présente sensiblement la même structure et la même géométrie que le composant 2 illustré à la figure 2. Le composant 2 montré dans la figure 3 diffère de celui du premier mode de réalisation uniquement par la géométrie du masque dur 140 et des grilles 131 et 132 et, en conséquent, la manque d'une étape de gravure sélective de ce masque.

Dans la figure 3, l'empilement du nanofil 120 et du masque dur 140 présente une symétrie par rapport à un plan incluant les directions X et Z. Ici, le masque dur 140 présente la même largeur que l'empilement du nanofil 120 et de la couche d'isolant de grille 150. Les faces latérales du masque dur 140 sont ici alignées avec les faces latérales de la couche d'isolant de grille 150. Les grilles 131 et 132 sont ici exemptes de débordement à la verticale de l'isolant de grille 150 et du nanofil 120. Une telle configuration facilite le positionnement des boîtes quantiques 21 et 22 vers les faces latérales de l'isolant de grille 150.

La figure 4 est une vue en coupe transversale d'un composant électronique 2, obtenu selon un deuxième mode de réalisation. Le composant 2 de la figure 4 présente sensiblement la même structure et la même géométrie que le composant 2 illustré à la figure 2. Le composant 2 obtenu selon le deuxième mode de réalisation diffère de celui du premier mode de réalisation uniquement par la géométrie du masque dur 140 et des grilles 131 et 132.

Dans le présent mode de réalisation, l'empilement du nanofil 120 et du masque dur 140 ne présente pas de symétrie par rapport à un plan incluant les directions X et Z. Dans le présent mode de réalisation, le masque dur 140 est moins large que l'empilement du nanofil 120 et de la couche d'isolant de grille 150. La grille 131 présente ici un débordement au-dessus de l'isolant de grille 150 et du nanofil 120. A contrario, une face latérale du masque dur 140 est ici alignée avec une face latérale de la couche d'isolant de grille 150, de sorte que la grille 132 est ici exempte de débordement au-dessus de l'isolant de grille 150 et du nanofil 120.

Une telle configuration permet d'obtenir un comportement différent pour les boîtes quantiques 21 et 22, ce qui peut s'avérer avantageux pour le fonctionnement du composant électronique 2. La boîte quantique 21 peut alors par exemple être une boîte quantique de lecture, la boîte quantique 22 pouvant alors être une boîte quantique de manipulation.

De plus, cette configuration permet de rapprocher la boîte quantique 21 de l'arête entre la face supérieure et une face latérale de la couche 150 d'isolant de grille. Par ailleurs, une telle configuration permet d'obtenir une distance entre les grilles 131 et 132 inférieure à la largeur minimale de photolithographie, selon un procédé de fabrication qui sera détaillé par la suite.

Dans les différents modes de réalisation, la couche d'isolant de grille 150 est avantageusement constituée d'une unique couche de matériau diélectrique, avantageusement une couche unique en un matériau diélectrique homogène. On peut également envisager que la couche d'isolant de grille 150 soit constituée d'une superposition d'une couche de diélectrique et d'une couche interfaciale. Avantageusement, la couche d'isolant de grille 150 n'inclut pas de nitrure, ni une superposition d'une couche de nitrure et d'une autre couche diélectrique.

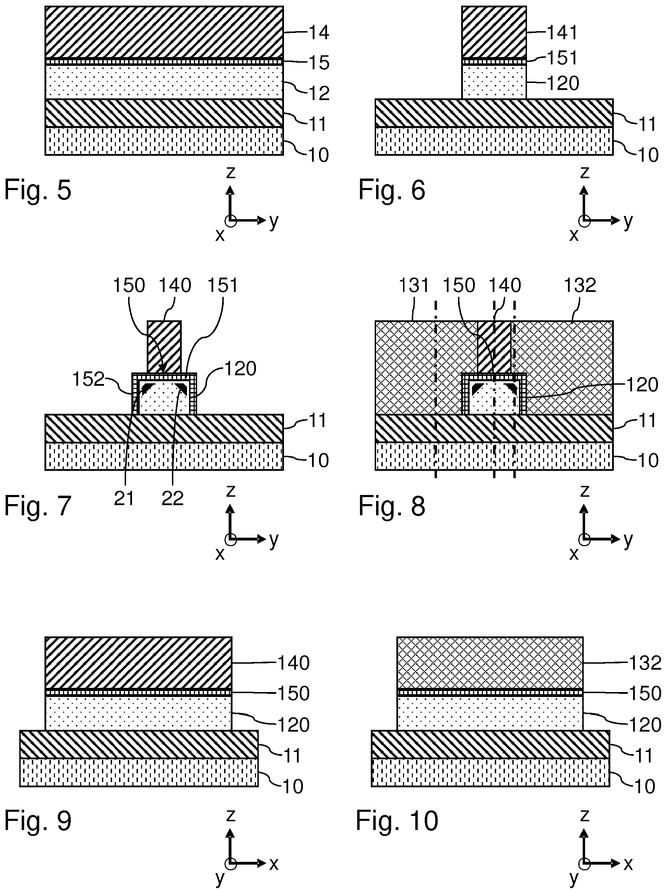

Les figures 5 à 7 illustrent différentes étapes d'un exemple d'un procédé de fabrication selon le premier mode de réalisation, selon des sections transversales au niveau d'une zone destinée à former les doubles boîtes quantiques.

À la figure 5, on fournit un empilement d'un substrat de type silicium sur isolant comportant une couche de silicium 10, recouverte d'une couche d'isolant enterré, recouverte d'une couche 12 de matériau semi-conducteur (par exemple en silicium ou alliage de silicium). La couche 12 est recouverte d'une couche 15 d'isolant de grille. La couche 15 est recouverte d'une couche de matériau diélectrique 14.

La couche 11 peut par exemple être réalisée en SiO₂. La couche 11 peut par exemple présenter une épaisseur comprise entre 10 et 145 nanomètres. Une telle couche 11 est fréquemment désignée par le terme UTBOX, ce qui permet d'envisager une polarisation de la couche 10 pour un contrôle électrostatique dans le nanofil de semi-conducteur à former.

La couche 12 est par exemple réalisée en silicium non intentionnellement dopé. La couche 12 peut par exemple présenter une épaisseur au moins égale à 5 nm, et de préférence comprise entre 8 et 12 nm.

La couche d'isolant de grille 15 est par exemple réalisée en SiO₂. La couche 15 peut par exemple présenter une épaisseur au moins égale à 3 nm, de préférence égale au moins à 4 nm. Une épaisseur relativement importante de la couche d'isolant de grille 15 favorise l'éloignement d'éventuelles charges parasites par rapport aux boîtes quantiques à former. On peut également envisager de former la couche d'isolant de grille 15 en un matériau de type Hk, par exemple du HfO₂.

La couche de matériau diélectrique 14 est par exemple réalisée en SiN. La couche de matériau diélectrique 14 peut également être réalisée (non limitativement) en SiO₂. La couche 14 peut par exemple présenter une épaisseur au moins égale à 40 nm, de préférence au moins égale à 50 m. L'épaisseur de la couche 14 est définie de façon à pouvoir réaliser ultérieurement une étape de planarisation (par polissage mécanochimique par exemple), et éventuellement de siliciuration. On forme ensuite un masque, par exemple par photolithographie, sur la couche de matériau diélectrique 14, selon un motif. La couche d'isolant de grille 15 est avantageusement formée par oxydation thermique de la face supérieure d'une couche 12 en silicium, avant le dépôt de la couche d'isolant de grille 15, ce qui permet d'éviter de piéger des charges à l'interface entre cette couche d'isolant de grille 15 et la couche 12. On évite ainsi de piéger des charges qui pourrait affecter le fonctionnement des boîtes quantiques à former.

À la figure 6, on a réalisé une gravure des couches 14, 15 et 12 selon le motif du masque formé sur la couche 14, avec arrêt sur la couche d'isolant enterré 11. La gravure peut par exemple être de type anisotrope, par exemple gravure de la zone active avec les espèces HBr/O₂/Cl₂. On obtient ainsi un nanofil semi-conducteur 120, surmonté d'une couche supérieure d'isolant de grille 151, surmontée d'un nanofil de matériau diélectrique 141. Du fait de cette étape de gravure commune, on garantit un alignement entre le nanofil 120 et le nanofil 141. La gravure peut avantageusement être mise en œuvre pour obtenir un nanofil semiconducteur 120 présentant une largeur comprise entre 8 et 30nm.

À la figure 7, on a réalisé une étape de gravure partielle sélective du nanofil 141 par rapport au nanofil 120, pour obtenir un masque dur 140 moins large que l'empilement du nanofil 120 et d'une couche d'isolant de grille 150. La gravure partielle sélective est par exemple une gravure isotrope avec du H₃PO₄. La gravure partielle sélective peut par exemple former un retrait de part et d'autre du masque dur 140 d'au moins 2nm par rapport au nanofil 120. Une telle gravure sélective permet de rendre le masque dur 140 moins large que le nanofil 120, et d'obtenir un masque dur 140 plus étroit que la largeur du motif de photolithographie.

À la figure 7, on a également procédé à la formation de faces latérales 152 de la couche d'isolant de grille 150. Les faces latérales 152 sont typiquement formées par oxydation thermique des faces latérales du nanofil 120 en silicium. La couche d'isolant de grille 150 formée présente ainsi des faces latérales 152 de part et d'autre du nanofil 120 et une face supérieure 151 sur le nanofil 120. L'épaisseur des faces latérales 152 est par exemple d'au moins 4nm, de préférence d'au moins 5nm.

À la figure 8, on a déposé un matériau de grille pleine plaque. Le matériau de grille est par exemple du polysilicium dopé ou un métal tel que du TiN. Du TiN peut aussi être déposé et être revêtu de polysilicium dopé. Le dépôt est réalisé de façon à présenter partout une hauteur à celle de l'empilement du masque dur 140 et du nanofil 120. Le dépôt du métal de grille est par exemple réalisé sur une épaisseur de 190nm.

On a ensuite procédé à une planarisation (par exemple par polissage mécanochimique) avec arrêt après avoir atteint le masque dur 140. La planarisation peut par exemple être poursuivie jusqu'à conserver une hauteur d'au moins 40 nm du masque dur 140. On obtient ainsi des grilles 131 et 132 de part et d'autre de l'empilement du nanofil 120 et du masque dur 140. La planarisation avec arrêt sur le masque dur 140 permet de supprimer la liaison du matériau de grille à l'aplomb du masque dur 140, et ainsi d'éviter un court-circuit entre les grilles 131 et 132. Les grilles 131 et 132 sont isolées électriquement l'une de l'autre par l'intermédiaire du masque dur de matériau diélectriques 140 et par l'intermédiaire de la couche d'isolant de grille 150. Les grilles 131 et 132 sont isolées électriquement du nanofil 120 par l'intermédiaire de la couche d'isolant de grille 150.

Les lignes en tiret-point à la figure 8 correspondent à différents plans de coupe :
- la figure 9 est une vue en coupe longitudinale selon un plan passant par le nanofils 120 et le masque dur 140, à ce stade du procédé de fabrication.
- la figure 10 est une vue en coupe longitudinale selon un plan passant par le nanofil 120 et la grille 132, à ce stade du procédé de fabrication.

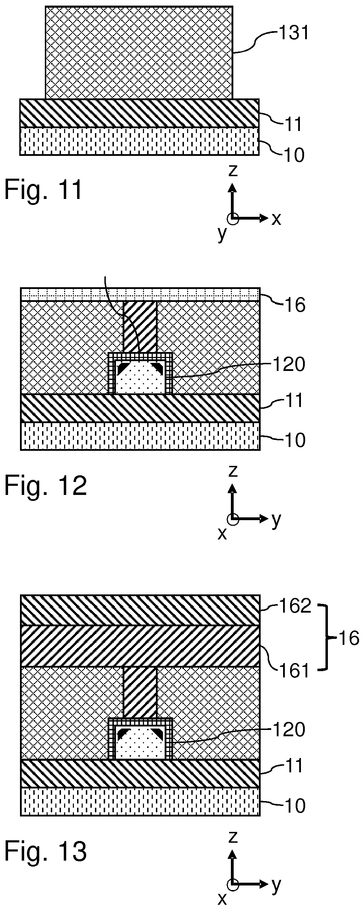

- la figure 11 est une vue en coupe longitudinale selon un plan passant par la grille 131, à ce stade du procédé de fabrication.

A la figure 12, on a procédé au dépôt d'une couche 16 pour former un masque dur, par exemple en oxyde. Selon la variante illustrée à la figure 13, la couche 16 inclut une superposition d'une couche de SiN 161 et d'une couche de SiO₂ 162. La couche de SiN 161 présente par exemple une épaisseur de 40nm. La couche de SiO₂ 162 présente par exemple une épaisseur de 27nm. Un masque de photolithographie est ensuite formé sur la couche 16 selon le motif des grilles et de l'isolant de séparation entre les grilles.

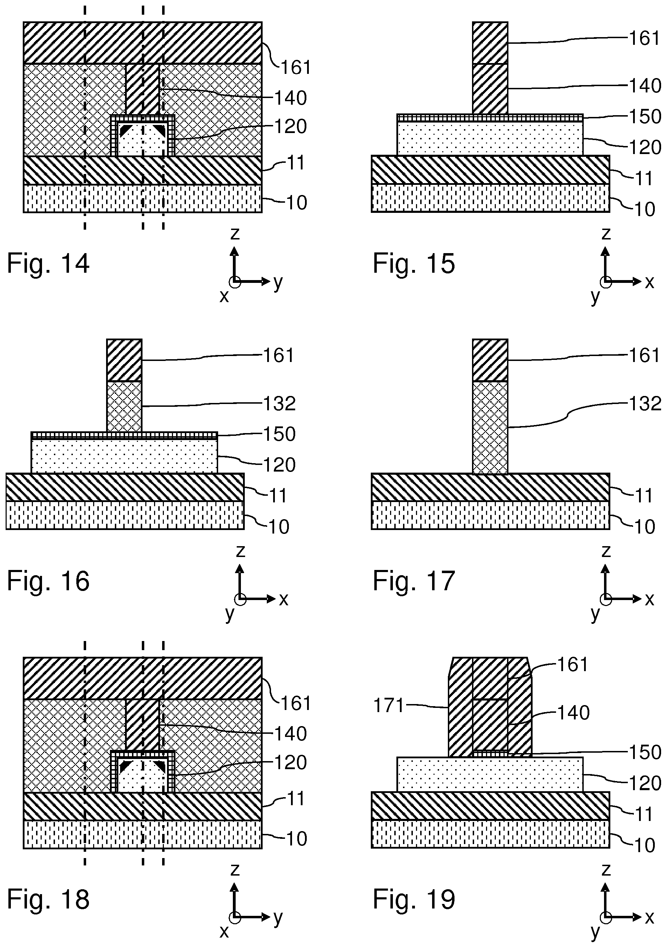

A la figure 14, on a poursuivi le procédé de la variante illustrée à la figure 13. On a ici procédé à une gravure des grilles 131 et 132 et l'isolant de séparation selon le motif de photolithographie, jusqu'à la couche 11 ou jusqu'à l'isolant de grille 150 le cas échéant. La gravure retire également la couche de SiN 161 et une partie du masque dur 140, de part et d'autre de la partie médiane du nanofil (en dehors du motif défini par photolithographie). L'isolant de grille 150 recouvrant le nanofil 120 au niveau de ses extrémités longitudinales est ainsi retiré. La couche de SiO₂ 162 a ici été retirée.

Les lignes en tiret-point à la figure 14 correspondent à différents plans de coupe :
- la figure 15 est une vue en coupe longitudinale selon un plan passant par le nanofils 120 et le masque dur 140, à ce stade du procédé de fabrication. Un empilement d'un résidu de la couche 161 et du masque dur 140 est conservé à la verticale de la partie médiane du nanofil 120. L'isolant de grille 150 recouvrant le nanofil 120 est découvert au niveau des extrémités longitudinales du nanofil 120. Cet empilement forme une séparation isolante entre les grilles 131 et 132 ;
- la figure 16 est une vue en coupe longitudinale selon un plan passant par le nanofil 120 et la grille 132, à ce stade du procédé de fabrication. Un empilement d'un résidu de la couche 161, de la grille 132 et du nanofil 120 est conservé à la verticale d'un bord de la partie médiane du nanofil 120 ;
- la figure 17 est une vue en coupe longitudinale selon un plan passant par la grille 131, à ce stade du procédé de fabrication. Un empilement d'un résidu de la couche 161 et de la grille 132 est conservé sur un côté de la partie médiane du nanofil 120.

Aux figures 18 à 21, on a formé des espaceurs 171, de part et d'autre longitudinalement par rapport aux grilles 131 et 132 et par rapport à la séparation isolante entre les grilles 131 et 132. Les espaceurs 171 sont par exemple formés en SiN. Les espaceurs 171 présentent par exemple une dimension comprise entre 10 et 40 nm selon la direction X.

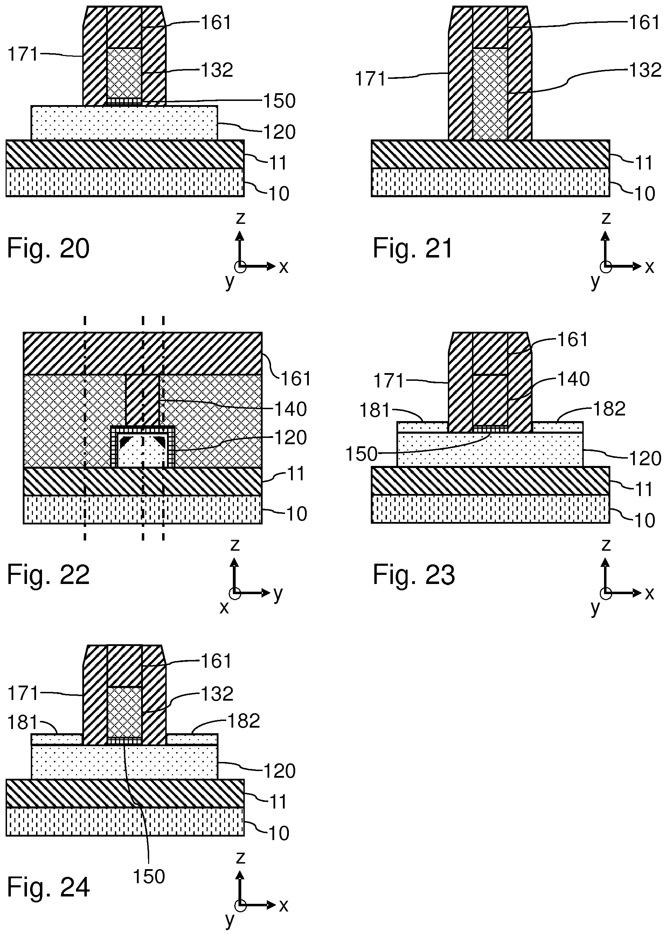

Aux figures 22 à 24, on a formé des électrodes de conduction relevées 181 et 182 sur le nanofil 120, de part et d'autre de sa partie médiane et de la séparation isolante. Les électrodes de conduction relevées peuvent par exemple être formées au moyen d'une croissance par épitaxie sur le nanofil 120.

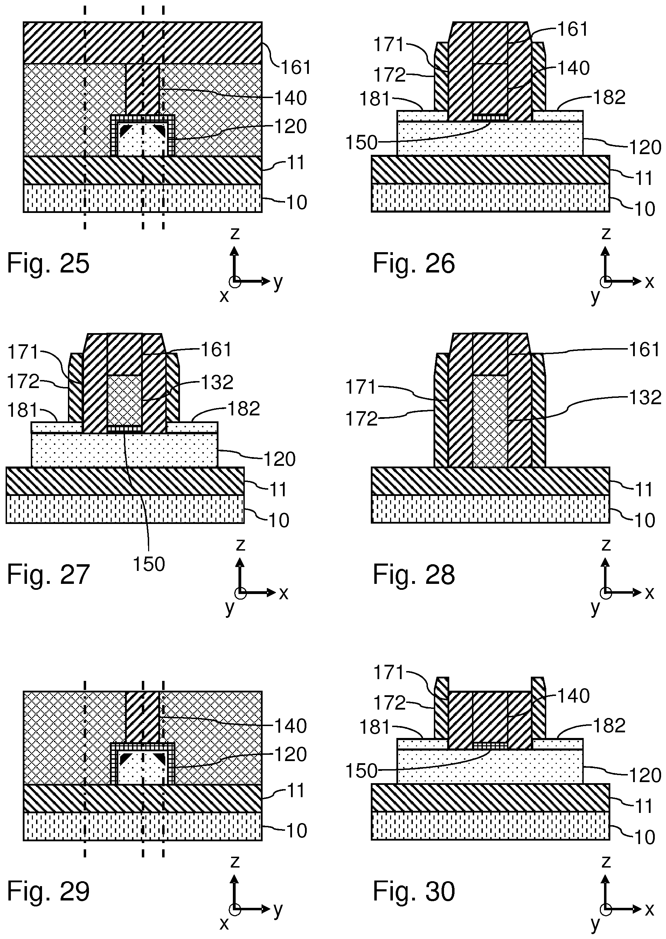

Aux figures 25 à 28, on a formé des espaceurs 172, contre des espaceurs 171 respectifs. Les espaceurs 172 sont donc positionnés de part et d'autre longitudinalement par rapport aux grilles 131 et 132 et par rapport à la séparation isolante entre les grilles 131 et 132. Les espaceurs 172 sont par exemple formés en SiO₂. Les espaceurs 172 sont destinés à protéger les faces latérales des espaceurs 171 lors d'une étape de retrait ultérieur de la couche 161, lorsque celle-ci est dans le même matériau que les espaceurs 171.

Aux figures 29 à 32, on a procédé au retrait de la couche 161 et de la partie supérieure des espaceurs 171, par gravure. On a ainsi ménagé un accès à la surface supérieure des grilles 131 et 132.

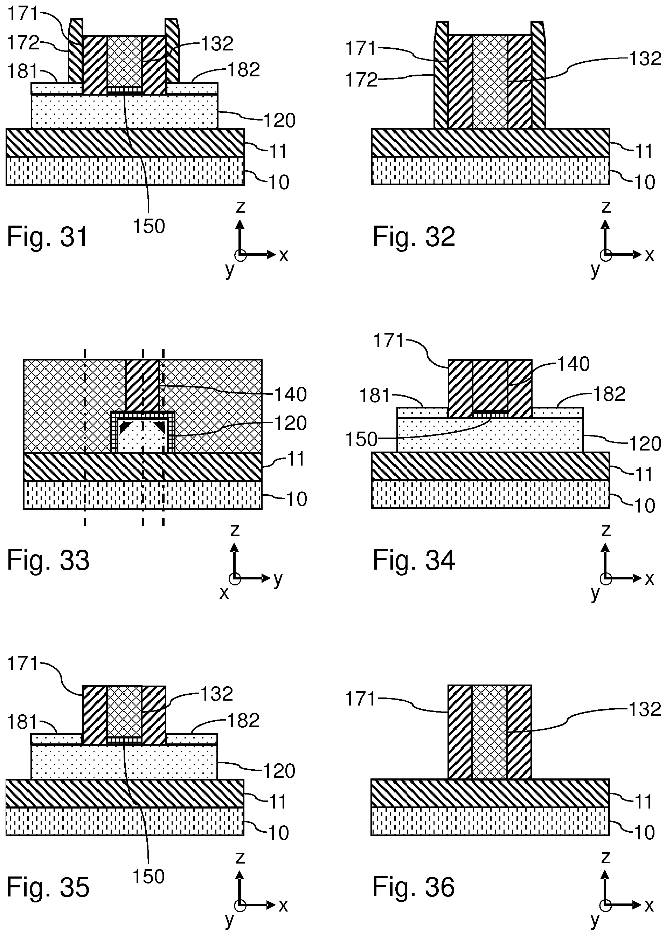

Aux figures 33 à 36, on a procédé au retrait des espaceurs 172 par une gravure sélective, de façon connue en soi. On a aussi avantageusement réalisé une implantation ionique de dopants dans les électrodes de conduction 181 et 182. On peut ensuite avantageusement mettre en œuvre une étape de siliciuration des faces supérieures électrodes de conduction et des grilles.

De façon connue en soi, on peut ensuite déposer une couche de passivation, puis former des contacts sur les grilles 131 et 132 et les électrodes de conduction 181 et 182.

Le procédé de fabrication d'un tel circuit électronique 1 peut faire appel à des étapes technologiques et des matériaux bien maîtrisés dans des procédés de fabrication en technologie CMOS. Par conséquent, un procédé de fabrication selon l'invention peut être mis en œuvre avec une maîtrise élevée et des coûts relativement réduits.

Selon une variante, le procédé de fabrication peut inclure une connexion électrique de la couche de semi-conducteur 10 à un circuit de polarisation (non illustré). Par polarisation de la couche de matériau semi-conducteur 10, avec une couche 11 suffisamment fine, on peut alors mettre en œuvre un contrôle électrostatique du nanofil 12 par cette polarisation.

Un procédé de fabrication selon le deuxième mode de réalisation peut être identique à celui du premier mode de réalisation pour les étapes décrites en référence aux figures 5 et 6. On procède ensuite à une étape de formation de faces latérales de la couche d'isolant de grille 150, par exemple par oxydation thermique des faces latérales du nanofil 120. A ce stade, les faces latérales du masque dur 140 sont alignées (selon la direction Y) avec les faces latérales de la couche d'isolant de grille 150.

On procède ensuite une implantation de H₂ sur seulement une des faces latérales du masque dur 140. On réalise ensuite une gravure sélective, par exemple de type HF. On procède ensuite au dépôt de matériau de grille pleine plaque décrit en référence à la figure 8. D'un côté du masque dur 140, le matériau de grille déposé est exempt de débordement à la verticale de l'isolant de grille 150 et du nanofil 120, du fait de l'alignement entre les faces latérales du masque dur 140 avec les faces latérales de la couche d'isolant de grille. De l'autre côté du masque dur 140, le matériau de grille présente un débordement à la verticale de l'isolant de grille 150 et du nanofil 120.

On a ensuite procédé à une planarisation (par exemple par polissage mécanochimique) avec arrêt après avoir atteint le masque dur 140, comme décrit pour le premier mode de réalisation.

Le procédé de fabrication selon le deuxième mode de réalisation peut ensuite être poursuivi comme décrit en référence aux figures 13 à 36 pour le premier mode de réalisation.

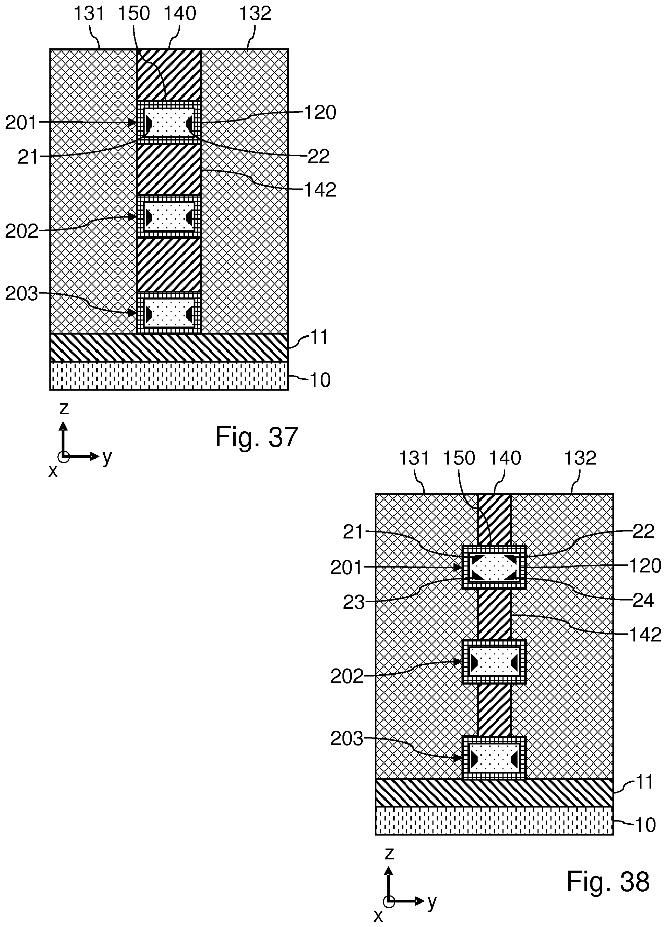

La figure 37 est une vue en coupe transversale d'un empilement vertical de composants électroniques 201, 202 et 203, pouvant être obtenu selon le procédé utilisé pour fabriquer la structure de la figure 3, qui n'est pas couvert par l'invention. Le substrat est ici identique à celui de la figure 3. Chacun des composants électroniques 201, 202 et 203 comprend :
- un nanofil de matériau semi-conducteur 120 ;
- une couche d'isolant de grille 150 recouvrant la partie médiane du nanofil 120 ;
- des boîtes quantiques 21 et 22 formées à proximité de face latérales opposées du nanofil 120, dans sa partie médiane.

Un masque dur de matériau diélectrique 140 est formé sur l'isolant de grille 150 du composant 201. Un nanofil de matériau diélectrique 142 est interposé entre l'isolant de grille du composant 201 et l'isolant de grille du composant 202. Un autre nanofil de matériau diélectrique est interposé entre l'isolant de grille du composant 202 et l'isolant de grille du composant 203. Les nanofils de matériau diélectrique présentent la même largeur que les nanofils 120 recouverts d'isolant de grille. Les faces latérales des nanofils de diélectrique (et du masque dur 140) sont donc alignées avec les faces latérales des couches d'isolant de grille.

Au niveau de la partie médiane des nanofils 120, des grilles de commande 131 et 132 sont ménagées de part et d'autre de l'empilement de composants électroniques 201 à 203, sur toute la hauteur de cet empilement. Les grilles 131 et 132 sont ici exemptes de débordement à la verticale des isolants de grille et des nanofils 120.

Une telle configuration permet d'augmenter la densité de boîtes quantiques pour une surface de substrat donnée.

La figure 38 est une vue en coupe transversale d'un empilement vertical de composants électroniques 201, 202 et 203, pouvant être obtenu selon une variante du premier mode de réalisation. Le substrat est ici identique à celui de la figure 2. Chacun des composants électroniques 201, 202 et 203 comprend :
- un nanofil de matériau semi-conducteur 120 ;
- une couche d'isolant de grille 150 recouvrant la partie médiane du nanofil 120 ;
- des boîtes quantiques 21 à 24 formées à proximité des arêtes du nanofil 120, dans sa partie médiane.

Un masque dur de matériau diélectrique 140 est formé sur l'isolant de grille 150 du composant 201 et est moins large que cet isolant de grille 150. Un nanofil de matériau diélectrique 142 est interposé entre l'isolant de grille du composant 201 et l'isolant de grille du composant 202 et est moins large que leur isolant de grille. Un autre nanofil de matériau diélectrique est interposé entre l'isolant de grille du composant 202 et l'isolant de grille du composant 203 et est moins large que leur isolant de grille. Les faces latérales des nanofils de diélectrique sont donc en retrait (selon la direction Y) par rapport aux faces latérales des couches d'isolant de grille.

Au niveau de la partie médiane des nanofils 120, des grilles de commande 131 et 132 sont ménagées de part et d'autre de l'empilement de composants électroniques 201 à 203, sur toute la hauteur de cet empilement. Les grilles 131 et 132 présentent ici un débordement à la verticale des isolants de grille et des nanofils 120. Avec une telle configuration des grilles de commande 131 et 132, on peut contrôler quatre boîtes quantiques pour chacun des composants électroniques 201 à 203.

Une telle configuration permet d'augmenter la densité de boîtes quantiques pour une surface de substrat donnée.

Dans les exemples décrits et illustrés, on utilise un substrat de type silicium sur isolant. L'invention s'applique bien entendu également à un substrat de type massif (pour Bulk en langue anglaise).

Dans les différents exemples de procédé de fabrication, la couche d'isolant de grille 150 est avantageusement formée avec une unique couche de matériau diélectrique, avantageusement une couche unique en un matériau diélectrique homogène. On peut également envisager que la couche d'isolant de grille 150 soit formée en deux étapes, avec une superposition d'une couche de diélectrique et d'une couche interfaciale. Avantageusement, la couche d'isolant de grille 150 formée n'inclut pas de nitrure, ni une superposition d'une couche de nitrure et d'une autre couche diélectrique.

## Revendications

1. Procédé de fabrication d'un composant électronique (2) à doubles boîtes quantiques (21, 22) et doubles grilles, comprenant la fourniture d'un substrat (10) surmonté d'un empilement d'une couche de matériau semi-conducteur (12) et d'une couche de matériau diélectrique (15) formée au-dessus de la couche de matériau semi-conducteur, comprenant les étapes de :
- formation d'un masque dur de diélectrique (141) sur la couche de matériau diélectrique (15);
- gravure de la couche de matériau diélectrique (15) et de la couche de matériau semi-conducteur (12) selon le motif du masque dur de diélectrique (141) de façon à former un empilement d'un nanofil semiconducteur (120) d'une couche de matériau diélectrique (151) et d'un masque dur de diélectrique (141) ;
- gravure sélective d'une partie de la largeur du masque dur de diélectrique (140) par rapport au nanofil semi-conducteur (120), puis
- formation de faces latérales (152) d'un isolant de grille (150) de part et d'autre du nanofil, puis
- déposer un matériau de grille pleine plaque ;
- réaliser une planarisation, jusqu'à atteindre le masque dur de diélectrique (140), de façon à former des première et deuxième grilles (131, 132) isolées électriquement l'une de l'autre de part et d'autre dudit nanofil.

2. Procédé de fabrication selon la revendication 1, dans lequel ladite gravure sélective partielle est mise en œuvre de sorte que le masque dur de diélectrique (140) présente de part et d'autre un retrait d'au moins 2 nm par rapport au nanofil (120).

3. Procédé de fabrication selon la revendication 2, dans lequel ladite gravure sélective partielle est mise en œuvre de façon à réduire la largeur du masque dur de diélectrique (140) d'au moins 2 nm.

4. Procédé de fabrication selon la revendication 1 ou 2, dans lequel ladite gravure sélective partielle rend l'empilement du masque dur de diélectrique (140) et du nanofil semi-conducteur (120) dissymétriques par rapport à un plan vertical incluant la direction longitudinale de ces nanofils.

5. Procédé de fabrication selon l'une quelconque des revendications précédentes, dans lequel ledit nanofil semiconducteur (120) est formé en alliage de Silicium, le procédé comprenant une étape de formation d'une couche d'oxyde thermique (15) par oxydation thermique de la partie supérieure de la couche de matériau semiconducteur (12) avant le dépôt de la couche de matériau diélectrique (14).

6. Procédé de fabrication selon l'une quelconque des revendications précédentes, dans lequel ledit nanofil semiconducteur (120) est formé en alliage de Silicium, dans lequel l'étape de formation de faces latérales (152) d'un isolant de grille (150) comprend une étape de formation d'une couche d'oxyde thermique (152) par oxydation thermique des bords du nanofil semiconducteur (120) avant le dépôt du matériau de grille.

7. Procédé de fabrication selon l'une quelconque des revendications précédentes, dans lequel ladite couche de matériau semi-conducteur fournie (12) est disposée sur un substrat (10) de type Silicium sur isolant.

8. Procédé de fabrication selon la revendication 7, comprenant une étape de connexion électrique d'un circuit de polarisation audit substrat (10).

9. Procédé de fabrication selon l'une quelconque des revendications précédentes, dans lequel ledit matériau de grille déposé comprend du Polysilicium dopé.

10. Procédé de fabrication selon l'une quelconque des revendications précédentes, dans lequel ledit nanofil semiconducteur (120) formé présente une largeur comprise entre 8 et 30 nm.

## Patentansprüche

1. Verfahren zur Herstellung eines elektronischen Bauelements (2) mit Doppelquantenpunkten (21, 22) und doppelten Gates, umfassend das Bereitstellen eines Substrats (10), das von einem Stapel aus einer Schicht aus Halbleitermaterial (12) und einer Schicht aus dielektrischem Material (15), die über der Schicht aus Halbleitermaterial ausgebildet ist, überdeckt ist, umfassend die folgenden Schritte:
- Bilden einer Hartmaske aus Dielektrikum (141) auf der Schicht aus dielektrischem Material (15);
- Ätzen der Schicht aus dielektrischem Material (15) und der Schicht aus Halbleitermaterial (12) gemäß dem Motiv der Hartmaske aus Dielektrikum (141), um einen Stapel aus einem Halbleiter-Nanodraht (120), einer Schicht aus dielektrischem Material (151) und einer Hartmaske aus Dielektrikum (141) zu bilden;
- selektives Ätzen eines Abschnitts der Breite der Hartmaske aus Dielektrikum (140) bezogen auf den Halbleiter-Nanodraht (120), dann
- Bilden von Seitenflächen (152) eines Gateisolators (150) beiderseits des Nanodrahts, dann
- Abscheiden eines Vollplatten-Gatematerials;
- Durchführen einer Planarisierung, bis die Hartmaske aus Dielektrikum (140) erreicht ist, um ein erstes und zweites Gate (131, 132), die voneinander elektrisch isoliert sind, beiderseits des Nanodrahts zu bilden.

2. Herstellungsverfahren nach Anspruch 1, wobei das teilweise selektive Ätzen so durchgeführt wird, dass die Hartmaske aus Dielektrikum (140) beiderseits einen Absatz von mindestens 2 nm bezogen auf den Nanodraht (120) aufweist.

3. Herstellungsverfahren nach Anspruch 2, wobei das teilweise selektive Ätzen so durchgeführt wird, dass die Breite der Hartmaske aus Dielektrikum (140) um mindestens 2 nm verringert wird.

4. Herstellungsverfahren nach Anspruch 1 oder 2, wobei das teilweise selektive Ätzen den Stapel der Hartmaske aus Dielektrikum (140) und des Halbleiter-Nanodrahts (120) bezogen auf eine vertikale Ebene, die die Längsrichtung dieser Nanodrähte enthält, unsymmetrisch macht.

5. Herstellungsverfahren nach einem der vorhergehenden Ansprüche, wobei der Halbleiter-Nanodraht (120) aus einer Siliziumlegierung gebildet ist, wobei das Verfahren einen Schritt des Bildens einer Schicht aus thermischem Oxid (15) durch thermische Oxidation des oberen Abschnitts der Schicht aus Halbleitermaterial (12) vor dem Abscheiden der Schicht aus dielektrischem Material (14) umfasst.

6. Herstellungsverfahren nach einem der vorhergehenden Ansprüche, wobei der Halbleiter-Nanodraht (120) aus Siliziumlegierung gebildet ist, wobei der Schritt des Bildens von Seitenflächen (152) eines Gateisolators (150) einen Schritt des Bildens einer Schicht aus thermischem Oxid (152) durch thermische Oxidation der Ränder des Halbleiter-Nanodrahts (120) vor dem Abscheiden des Gatematerials umfasst.

7. Herstellungsverfahren nach einem der vorhergehenden Ansprüche, wobei die bereitgestellte Schicht aus Halbleitermaterial (12) auf einem Substrat (10) vom Typ Silizium auf einem Isolator angeordnet ist.

8. Herstellungsverfahren nach Anspruch 7, umfassend einen Schritt des elektrischen Anschließens einer Polarisierungsschaltung an das Substrat (10).

9. Herstellungsverfahren nach einem der vorhergehenden Ansprüche, wobei das abgeschiedene Gatematerial dotiertes Polysilizium umfasst.

10. Herstellungsverfahren nach einem der vorhergehenden Ansprüche, wobei der gebildete Halbleiter-Nanodraht (120) eine Breite zwischen 8 und 30 nm aufweist.

## Claims

1. Process for fabricating an electronic component (2) incorporating double quantum dots (21, 22) and split gates, comprising providing a substrate (10) surmounted with a stack of a semiconductor layer (12) and of a dielectric layer (15) that is formed above the semiconductor layer, comprising the steps of:
- forming a dielectric hard mask (141) on the dielectric layer (15);
- etching the dielectric layer (15) and the semiconductor layer (12) with the pattern of the dielectric hard mask (141), so as to form a stack of a semiconductor nanowire (120), of a dielectric layer (151) and of a dielectric hard mask (141);
- using a selective etch to etch a portion of the width of the dielectric hard mask (140) selectively with respect to the semiconductor nanowire (120), then
- forming lateral faces (152) of a gate insulator (150) on either side of the nanowire, then
- depositing a gate material on all the wafer;
- carrying out a planarization, until the dielectric hard mask (140) is reached, so as to form first and second gates (131, 132) that are electrically insulated from each other on either side of said nanowire.

2. Fabrication process according to Claim 1, wherein said selective partial etch is carried out so that the dielectric hard mask (140) has, on either side, an indentation of at least 2 nm with respect to the nanowire (120).

3. Fabrication process according to Claim 2, wherein said selective partial etch is carried out so as to decrease the width of the dielectric hard mask (140) by at least 2 nm.

4. Fabrication process according to Claim 1 or 2, wherein said selective partial etch makes the stack of the dielectric hard mask (140) and of the semiconductor nanowire (120) asymmetric with respect to a vertical plane including the longitudinal direction of these nanowires.

5. Fabrication process according to any one of the preceding claims, wherein said semiconductor nanowire (120) is formed from silicon alloy, the process comprising a step of forming a thermal-oxide layer (15) by thermal oxidation of the top portion of the semiconductor layer (12) before the deposition of the dielectric layer (14).

6. Fabrication process according to any one of the preceding claims, wherein said semiconductor nanowire (120) is formed from silicon alloy, and wherein the step of forming lateral faces (152) of a gate insulator (150) comprises a step of forming a thermal-oxide layer (152) by thermal oxidation of the edges of the semiconductor nanowire (120) before the deposition of the gate material.

7. Fabrication process according to any one of the preceding claims, wherein said provided semiconductor layer (12) is located on a silicon-on-insulator substrate (10).

8. Fabrication process according to Claim 7, comprising a step of electrically connecting a biasing circuit to said substrate (10).

9. Fabrication process according to any one of the preceding claims, wherein said deposited gate material comprises doped polysilicon.

10. Fabrication process according to any one of the preceding claims, wherein said formed semiconductor nanowire (120) has a width comprised between 8 and 30 nm.
